Europäisches Patentamt

European Patent Office

Office européen des brevets

(19)

(11) Publication number· **0 079 135**
**A2**

(12) **EUROPEAN PATENT APPLICATION**

(21) Application number: **82305459.8**

(22) Date of filing: **14.10.82**

(51) Int. Cl.³: **B 23 K 35/02**
**B 23 K 35/36**
**//H05K3/34**

(30) Priority: **06.11.81 GB 8133548**

(43) Date of publication of application:
**18.05.83 Bulletin 83 20**

(84) Designated Contracting States:
**DE FR IT NL**

(71) Applicant: **Multicore Solders Limited**
**Maylands Avenue Hemel Hempstead**
**Hertfordshire HP2 7EP(GB)**

(72) Inventor: **Arbib, Gordon Francis**
**Kelsey House Wood Lane End**
**Hemel Hempstead Hertfordshire, HP2 4RF(GB)**

(72) Inventor: **Rubin, Wallace**
**Kelsey House Wood Lane End**
**Hemel Hempstead Hertfordshire, HP2 4RF(GB)**

(72) Inventor: **Shaw, Doris**
**5 Shendish Edge London Road**
**Hemel Hempstead Hertfordshire(GB)**

(74) Representative· **Kosmin, Gerald Emmanuel et al,**
**HASELTINE, LAKE & CO. Hazlitt House 28 Southampton**
**Buildings Chancery Lane**
**London, WC2A 1AT(GB)**

(54) **Method of producing preformed solder material for use in soldering electronic components.**

(57) The production of preformed solder material in the shape of, for example, rings or washers is effected in a more convenient and less costly manner by feeding a thickened fluxed solder paste on to a sheet carrier material, preferably a flexible carrier material, so as to deposit on the carrier material a plurality of the desired preformed shapes and then heating the preformed shapes on the carrier material so as to harden them and cause them to releasably adhere to the sheet of carrier material. The fluxed solder paste is fed on to the sheet of carrier material by a screen printing technique or by means of a stencil. When required for use, the preformed shapes of fluxed solder material can be peeled off the carrier sheet or, if the carrier material is a heat shrinkable plastics film, they can be positioned whilst still on the carrier material to which heat is then applied to cause the plastics film to shrink-wrap the soldering site.

EP 0 079 135 A2

- 1 -

"METHOD OF PRODUCING PREFORMED
SOLDER MATERIAL FOR USE IN
SOLDERING ELECTRONIC COMPONENTS"

This invention relates to soldering with soft solder, such as tin or a tin/lead alloy. Such soldering is conventionally employed in the production of electrical and electronic apparatus, for example in mounting electronic components on printed circuit boards incorporated in electronic watches and cameras.

For certain soldering operations, particularly those of an intricate nature such as, for example, in the manufacture of printed circuit assemblies in the electronics industry, it is known to employ solder in conjunction with a soldering flux in the form of a soldering paste composed of particulate solder and a soldering flux, for example rosin, in a solvent vehicle, which paste is deposited in predetermined locations and in required amounts by means of, for example, screen printing or stencilling, following which the required components are placed in position on the deposited paste which is then heated to effect concomitant volatilisation of the vehicle and soldering. However this method of soldering has a number of limitations, for instance screen printing or stencilling can only be effectively carried out on a completely flat surface such as a printed circuit board on which no components have previously been mounted, and it requires the setting up of a screen printing or stencilling facility in the overall soldering operation, which may not be practicable or commercially viable.

It is also known to produce individual solid preformed shapes of solder or flux-cored solder, for example rings, washers and discs, generally by punching the preformed shape from a solder, or flux-cored solder, tape. Whilst such individual preformed shapes are advantageous in some soldering operations, particularly when a precise volume of solder is to be applied to a relatively inaccessible part of an assembly, nevertheless they are relatively time-consuming to use, since each preformed shape needs to be placed in the required position generally by hand, and are also costly to produce since they require expensive tooling to punch out from solder tape all the different shapes and sizes which may be required.

It is an object of the present invention to provide a more economical method of producing preformed solder shapes which will obviate the use of expensive tooling to produce a large range of preformed shapes of various sizes.

According to the invention there is provided a method of producing fluxed solder preformed shapes, which comprises forming a thickened fluxed solder paste comprising a particulate solder, a flux material, a plasticiser and/or a thickening agent, and an organic liquid vehicle; feeding the resulting fluxed solder paste by means of a screen printing technique or by a stencil on to a sheet of carrier material so that the fluxed solder paste is deposited on the carrier material in a plurality of the required preformed shapes; and thereafter subjecting the preformed shapes to an elevated temperature to volatilise the organic liquid and cause the resulting hardened preformed shapes to releasably adhere to the sheet of carrier material.

The preformed shapes are advantageously retained on the carrier material until required for use, at which time they can be readily removed therefrom. The carrier material may be rigid or advantageously flexible, e.g. paper, since in the latter case, the sheet of flexible carrier material bearing the preformed shapes may if desired be rolled up and thereby transported in an easier manner than the known punched preformed shapes and with less likelihood of the preformed shapes being damaged by distortion or sticking to each other. A further advantage of employing a flexible carrier material is that, by retaining the preformed shapes on the sheet of flexible carrier material prior to use, a plurality of the shapes may be positioned simultaneously by, for example, passing the pins of an electrical connector through the flexible sheet and then removing the latter so as to leave the plurality of preformed shapes in position ready for the soldering operation. This would of course represent a considerable labour saving compared with the conventional positioning of each punched preformed shape individually over the pins of such a connector.

The thickened fluxed solder paste employed in the present invention can be produced by mixing together the essential constituents in a suitable known manner. The particulate solder may comprise any suitable soft solder, for example a tin/lead alloy, which may be in a spherical or non-spherical powder form. The solder may have a particle size in the range from 450 to 200 mesh (BSS), i.e. 30 to 75 microns. The amount of particulate solder present in the paste may vary but will generally be in the range from 70 to 95% by weight, based on the total fluxed solder paste.

The flux material may comprise any suitable noncorrosive flux material, for example rosin (colophony) or pentaerythritol tetrabenzoate (see our British Patent Specification No. 1,550,648). The flux material may be present in the range from 30 to 65 wt.%, based on the total paste constituents excluding the particulate solder.

The thickening agent which will normally be employed in the paste to prevent settling of the particulate solder may be, for example, ethyl cellulose or hydrogenated castor oil. The use of ethyl cellulose is advantageous in that this can act both as a thickener and as a plasticiser, so that the presence in the paste of a separate plasticiser may then not be necessary. If desired more than one thickening agent may be used. The thickening agent may be present in a total amount of from 3 to 25 wt.%, based on the paste excluding the particulate solder.

The plasticiser, which may be present in the paste to provide sufficient flexibility in the dry preformed shape, should be one which is compatible with the flux material employed. The plasticiser may be present in an amount of from 3 to 20% by weight, based on the flux material content of the paste. Suitable plasticisers are, for example, dibutyl phthalate and a hydrogenated methyl ester of rosin.

The organic liquid vehicle employed in the production of the paste is preferably one which is capable of dissolving both the flux material and the plasticiser employed. Suitable organic liquids are, for example, ethyl glycol acetate (i.e. ethylene glycol monoethyl ether acetate or 2-ethoxyethyl acetate), butyl digol acetate (i.e. diethylene glycol monobutyl ether acetate), polyethylene glycol, white spirit, n-butanol, and methyl-isobutyl ketone. Advantageously a mixture of two or more such liquids is generally used. The organic liquid or liquids will generally be present in a total amount of from 35 to 70 wt.%, based on the paste excluding the particulate solder.

The flexible carrier material which is preferably employed in the invention will generally be a sheet of paper, plastics material or fabric which may be coated with a substance which will assist release of the preformed shapes therefrom, for example a silicone-based material. In one embodiment of the invention the flexible carrier material may comprise a heat shrinkable plastics film, for example poly(vinylidene fluoride) film, which is advantageous in the case where a plurality of the preformed shapes are to be positioned simultaneously on a workpiece whilst still retained on the plastics film, since after the film bearing the preformed shapes has been correctly positioned, heat can be applied to the film, for example by means of an infra-red heater, so as to effect simultaneous melting of the preformed solder shapes and shrink-wrapping of the workpiece by the plastics film to provide a protective covering of the workpiece against contamination.

The formation of the preformed shapes of fluxed solder can be effected by means of an appropriately shaped rigid stencil or by means of a suitable screen printing technique involving the use of a screen printing machine, preferably an automatic screen printing apparatus such as, for example, the DEK 400 screen printing machine manufactured by DEK Printing Machines Limited. In such a screen printing machine, the screen is composed of a resilient gauze which is appropriately masked off to leave the required pattern of preformed shapes to be printed. The gauze may be formed from stainless steel wire or a polyamide or polyester filamentary material, polyester being the preferred material. In forming the preformed shaped fluxed solder, the fluxed solder paste is deposited at one edge of the screen and pushed across to the opposite edge by means of an inclined flexible blade, such as a polyurethane rubber blade (generally referred to as a squeegee). This forces the paste through the open areas of the screen and on to a sheet of carrier material, preferably a flexible material, e.g. a continuous paper sheet, positioned adjacent to the lower surface of the screen. Removal of the screen causes the shaped mass of fluxed solder paste to remain behind on the carrier material, and the shaped mass is then dried, for example by heating in an oven at an elevated temperature in the range of, for example, from 40 to 85 $^{\circ}$C, to form the hardened preformed shapes, which adhere to the carrier material by virtue of the flux material present therein.

The following Examples illustrate the invention.

### EXAMPLE 1

A thickened fluxed solder paste was formed by blending together in a mixer the following constituents:-

| | % by weight |
|---|---|
| Activated rosin flux (Ersin 362) | 6.6 |
| Hydrogenated methyl ester of rosin | 0.8 |
| Ethyl cellulose N100 (thickener/plasticiser) | 1.2 |
| Ethyl glycol acetate | 4.8 |
| Butyl digol acetate | 0.6 |
| n-Butanol | 1.0 |
| Solder powder (62/36/2 tin/lead/silver)-240 mesh | 85.0 |
| | 100.0 |

The resulting paste was screen printed on to a silicone coated Kraft paper by means of a DEK 400 screen printing machine to form fluxed solder preformed washers having a wet thickness of 300 microns.. These were then dried by heating the preformed washers and backing paper in an oven for 60 minutes at $70^{\circ}$C. On cooling the fluxed solder preformed washers were found to be tough but sufficiently flexible for the required use, and were easily detachable from the backing paper.

## EXAMPLE 2

A thickened fluxed solder paste was formed by blending together in a mixer the following constituents:-

| | % by weight |
|---|---|
| Pentaerythritol tetrabenzoate flux (Xersin 2012) | 5.0 |
| Ethyl cellulose N 100 | 1.5 |
| Ethyl glycol acetate | 6.5 |
| Butyl digol acetate | 1.0 |
| n-Butanol | 1.0 |
| Solder powder (60/40 tin/lead) - 300 mesh | 85.0 |
| | 100.0 |

The resulting paste was formed into fluxed solder preformed washers in the manner described in Example 1 except that instead of the silicone coated Kraft paper there was used as a carrier material a heat shrinkable poly(vinylidene fluoride) film.

### EXAMPLE 3

A thickened fluxed solder paste was formed by blending together in a mixer the following constituents:-

|  | % by weight |
| --- | --- |
| Mildly activated rosin flux | 6.0 |
| Dibutyl phthalate | 1.0 |
| Hydrogenated castor oil | 0.8 |
| Ethyl cellulose | 0.6 |
| White spirit | 5.3 |
| Polyethylene glycol 200 | 0.3 |
| n-Butanol | 1.0 |
| Solder powder (60/40 tin/lead) - 200 mesh | 85.0 |
|  | 100.0 |

The resulting paste was formed into fluxed solder preformed washers in the manner described in Example 1.

CLAIMS:

1.    A method of producing fluxed solder preformed shapes suitable for use in soldering electronic components, which comprises:

(i)    forming a thickened fluxed solder paste comprising a particulate solder, a flux material, a plasticiser and/or a thickening agent, and an organic liquid vehicle;

(ii)    feeding the resulting fluxed solder paste by means of a screen printing technique or by a stencil on to a sheet of carrier material so that the fluxed solder paste is deposited on the carrier material in a plurality of the required preformed shapes; and

(iii)    thereafter subjecting the preformed shapes to an elevated temperature sufficient to volatilise the organic liquid and cause the resulting hardened preformed shapes to releasably adhere to the sheet of carrier material.

2.    A method according to Claim 1, wherein the sheet of carrier material is formed from a flexible material.

3.    A method according to Claim 2, wherein the flexible carrier material is a silicone coated paper.

4.    A method according to Claim 2, wherein the flexible carrier material is a heat shrinkable plastics film.

5.    A method according to Claim 1, 2, 3 or 4, wherein the fluxed solder paste is formed from particulate solder, a flux material, at least one thickening agent, optionally a plasticiser, and an organic liquid vehicle composed of at least one organic liquid.

6.      A method according to Claim 5, wherein the fluxed solder paste comprises from 70 to 95% by weight, based on the total paste, of the particulate solder having a particle size of from 30 to 75 microns, and, based on the paste excluding the particulate solder, from 30 to 65% by weight of the flux material, from 3 to 25% by weight of thickening agent, and from 35 to 70% by weight of organic liquid vehicle.

7.      A method according to Claim 6, wherein the fluxed solder paste includes from 3 to 20% by weight of plasticiser, based on the flux material content of the paste.

8.      A method according to any preceding claim, wherein the preformed shapes are subjected in step (iii) to an elevated temperature of from 40 to 85°C.

9.      A method according to any preceding claim, wherein the fluxed solder paste is formed into preformed washers.

10.      Fluxed solder preformed shapes whenever produced by the method claimed in any preceding claim.